(19) Europäisches Patentamt / European Patent Office / Office européen des brevets

(11) **EP 4 760 276 A1**

(12) **EUROPEAN PATENT APPLICATION**
published in accordance with Art. 153(4) EPC

(43) Date of publication:
**17.06.2026 Bulletin 2026/25**

(21) Application number: **24850677.6**

(22) Date of filing: **19.06.2024**

(51) International Patent Classification (IPC):
**G01R 27/02** (2006.01)　　**B60L 3/00** (2019.01)
**B60L 58/10** (2019.01)

(86) International application number:
**PCT/CN2024/100168**

(87) International publication number:
**WO 2025/031025 (13.02.2025 Gazette 2025/07)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.08.2023　CN 202311001079**

(71) Applicant: **BYD Company Limited**
**Shenzhen, Guangdong 518118 (CN)**

(72) Inventors:
• **WANG, Peng**
  **Shenzhen, Guangdong 518118 (CN)**
• **YIN, Lianjie**
  **Shenzhen, Guangdong 518118 (CN)**
• **WANG, Chengzhi**
  **Shenzhen, Guangdong 518118 (CN)**

(74) Representative: **Mathys & Squire**
**32 London Bridge Street**
**The Shard**
**London SE1 9SG (GB)**

(54) **INSULATION DETECTION CIRCUIT AND METHOD, BATTERY MANAGEMENT SYSTEM AND VEHICLE**

(57)　An insulation detection circuit and method, a battery management system, and a vehicle are provided. The circuit includes: a power supply unit, suitable for providing a first power supply and a second power supply, a supply voltage of the first power supply being different from a supply voltage of the second power supply; a switching unit, suitable for switching the power supply unit to be connected to a positive terminal of a load or a negative terminal of the load; and a voltage detection unit, configured to detect a voltage between the first power supply and a ground terminal, and detect a voltage between the second power supply and the ground terminal. The voltages detected by the voltage detection unit are used to determine insulation resistance. In this way, regardless of whether the power supply unit is connected to the positive terminal or the negative terminal of the load, detection of the insulation resistance at the ground terminal can be implemented.

Insulation detection circuit 100 — Switching unit 20 — Power supply unit 10 — Voltage detection unit 30 — Load L — Ground terminal GND

FIG. 1

**Description**

**CROSS-REFERENCE TO RELATED APPLICATIONS**

The present disclosure claims priority to Chinese Patent Application No. 202311001079.5, filed with the China National Intellectual Property Administration on August 9, 2023 and entitled "INSULATION DETECTION CIRCUIT AND METHOD, BATTERY MANAGEMENT SYSTEM, AND VEHICLE", which is incorporated herein by reference in its entirety.

**TECHNICAL FIELD**

The present disclosure relates to the field of insulation detection, and in particular, to an insulation detection circuit and method, a battery management system, and a vehicle.

**BACKGROUND**

New energy vehicle technologies have become a leading area in current automotive development. Electric vehicles are continuously capturing market share from traditional internal combustion engine vehicles. A battery management system (BMS) is one of the core technologies among the "three electric" systems in new energy vehicles. The battery management system is responsible for functions such as high-voltage interlock, state of charge (SOC), state of health (SOH), relay driving, cell voltage, and temperature acquisition. Insulation detection serves as an important indicator for evaluating insulation performance between high voltage and low voltage of the battery management systems.

**SUMMARY**

An insulation detection circuit and method, a battery management system, and a vehicle are provided. Regardless of whether a power supply unit is connected to a positive terminal or a negative terminal of a load, detection of insulation resistance at a ground terminal can be implemented.

According to a first aspect, the present disclosure provides an insulation detection circuit. The insulation detection circuit includes: a power supply unit, suitable for providing a first power supply and a second power supply, a supply voltage of the first power supply being different from a supply voltage of the second power supply; a switching unit, suitable for switching the power supply unit to be connected to a positive terminal of a load or a negative terminal of the load; and a voltage detection unit, configured to detect a voltage between the first power supply and a ground terminal, and detect a voltage between the second power supply and the ground terminal. The voltages detected by the voltage detection unit are used to determine an insulation resistance.

According to the insulation detection circuit in embodiments of the present disclosure, regardless of whether the power supply unit is connected to the positive terminal or the negative terminal of the load, detection of insulation resistance at the ground terminal can be implemented.

According to a second aspect, the present disclosure provides a battery management system, including the foregoing insulation detection circuit.

According to the battery management system in the embodiments of the present disclosure, regardless of whether a power supply unit is connected to a positive terminal or a negative terminal of a load, detection of insulation resistance at a ground terminal can be implemented by using the insulation detection circuit.

According to a third aspect, the present disclosure provides a vehicle, wherein the vehicle includes the foregoing battery management system.

According to the vehicle in the embodiments of the present disclosure, regardless of whether a power supply unit is connected to a positive terminal or a negative terminal of a load, detection of insulation resistance at a ground terminal can be implemented by using the battery management system.

According to a fourth aspect, the present disclosure provides an insulation detection method, which is applied to a battery management system. The battery management system includes a power supply unit and a switching unit. The power supply unit is suitable for providing a first power supply and a second power supply, a supply voltage of the first power supply being different from a supply voltage of the second power supply. The switching unit is suitable for switching the power supply unit to be connected to a positive terminal of a load and a negative terminal of the load. The method includes: detecting a voltage between the first power supply and a ground terminal, and detecting a voltage between the second power supply and the ground terminal; and determining an insulation resistance based on the detected voltages.

According to the insulation detection method in the embodiments of the present disclosure, regardless of whether the power supply unit is connected to the positive terminal or the negative terminal of the load, detection of insulation resistance at the ground terminal can be implemented.

The additional aspects and advantages of the present disclosure are partially set forth in the following descriptions, and partially clear from the following descriptions, or understood through practice of the present disclosure.

**BRIEF DESCRIPTION OF DRAWINGS**

FIG. 1 is a schematic diagram of a structure of an insulation detection circuit according to an embodiment of the present disclosure;

FIG. 2 is a schematic diagram of a structure of an insulation detection circuit according to a first specific embodiment of the present disclosure;

FIG. 3 is a schematic diagram of a structure of an insulation detection circuit according to a second specific embodiment of the present disclosure;

FIG. 4 is a schematic diagram of a structure of an insulation detection circuit according to a third specific embodiment of the present disclosure;

FIG. 5 is a schematic diagram of a battery management system according to an embodiment of the present disclosure;

FIG. 6 is a schematic diagram of a vehicle according to an embodiment of the present disclosure; and

FIG. 7 is a schematic flowchart of an insulation detection method according to an embodiment of the present disclosure.

**DESCRIPTION OF EMBODIMENTS**

The following describes in detail embodiments of the present disclosure. Examples of the embodiments are shown in the accompanying drawings, where same or similar reference numerals throughout represent same or similar elements or elements having same or similar functions. The embodiments described below with reference to the accompanying drawings are examples, and are intended to explain the present disclosure and shall not be construed as limitations on the present disclosure.

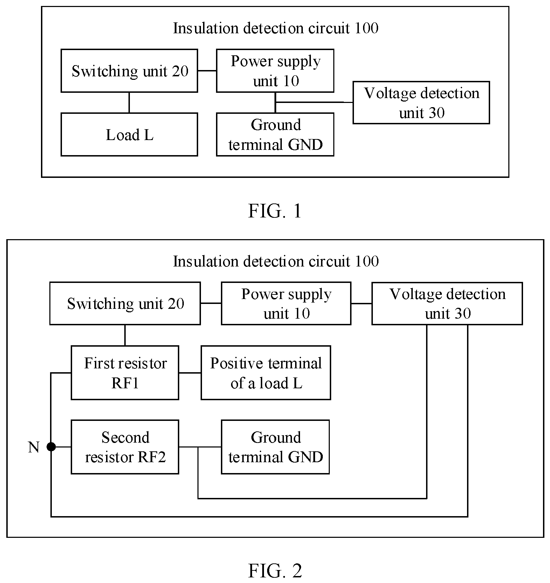

FIG. 1 is a schematic diagram of a structure of an insulation detection circuit according to an embodiment of the present disclosure. As shown in FIG. 1, an insulation detection circuit 100 includes a power supply unit 10, a switching unit 20, and a voltage detection unit 30.

In this example, the power supply unit 10 is suitable for providing a first power supply and a second power supply. A supply voltage of the first power supply is different from a supply voltage of the second power supply.

Specifically, with introduction of the supply voltage of the first power supply and the supply voltage of the second power supply, calculation of insulation resistance at a load terminal does not depend on a battery voltage or a power generation voltage of a load L. In other words, even when the load L is in a discharge mode, measurement of the insulation resistance at the load terminal is not affected, thereby expanding an applicable range of the insulation detection circuit 100. The supply voltage of the first power supply and the supply voltage of the second power supply may be provided by a transformer, a DC/DC (Direct Current/Direct Current, DC converter), or a small battery. In accordance with the national standard requirements, the voltage shall not exceed 60 V, and due to limitation by the load terminal, a residual voltage shall not exceed a standard value. Therefore, for example, the supply voltage of the first power supply is 48 V (volts), and the supply voltage of the second power supply is 24 V (volts). It will be noted that, although a macro principle is feasible when the supply voltage of the first power supply may be 24 V and the supply voltage of the second power supply may be 12 V (volts), an actual effect in small-scale experiments is poor, resulting in an excessively large test error.

In this example, the switching unit 20 is suitable for switching the power supply unit 10 to be connected to a positive terminal of the load L or a negative terminal of the load L. The voltage detection unit 30 detects a voltage between the first power supply and a ground terminal GND, and detects a voltage between the second power supply and the ground terminal GND. The voltages detected by the voltage detection unit 30 are used to determine an insulation resistance.

Specifically, the voltage between the first power supply and the ground terminal GND may be detected when the power supply unit 10 supplies power to the first power supply for 450 ms, that is, after the circuit stabilizes. Similarly, the voltage between the second power supply and the ground terminal GND may be detected when the power supply unit 10 supplies power to the second power supply for 450 ms, that is, after the circuit stabilizes.

In this way, regardless of whether the power supply unit is connected to the positive terminal or the negative terminal of the load, detection of the insulation resistance at the ground terminal can be implemented.

As an example, the voltage detection unit 30 is configured to: when the power supply unit 10 is connected to the positive terminal,

if the power supply unit 10 provides the first power supply, detect the voltage between the first power supply and the ground terminal GND to obtain a first detection voltage (U2); or if the power supply unit 10 provides the second power supply, detect the voltage between the second power supply and the ground terminal GND to obtain a second detection voltage (U4).

EP 4 760 276 A1

The voltage detection unit 30 is further configured to: when the power supply unit 10 is connected to the negative terminal,
if the power supply unit 10 provides the first power supply, detect the voltage between the first power supply and the ground terminal GND to obtain a third detection voltage (U2'); or if the power supply unit 10 provides the second power supply, detect the voltage between the second power supply and the ground terminal GND to obtain a fourth detection voltage (U4').

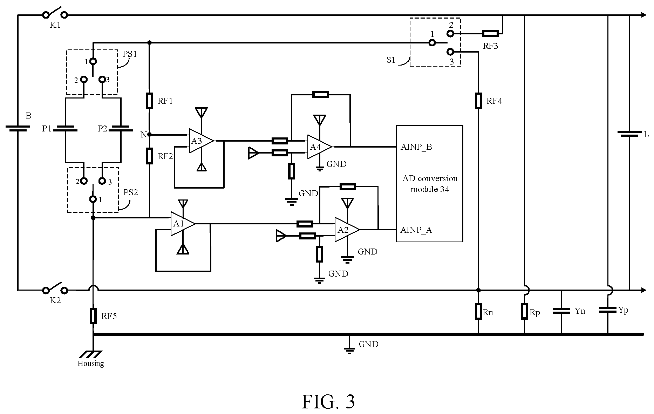

The first detection voltage (U2) to the fourth detection voltage (U4') are used to determine an insulation resistance Rp between the positive terminal and the ground terminal GND and an insulation resistance Rn between the negative terminal and the ground terminal GND (refer to FIG. 3).

It should be noted that, referring to FIG. 3, the insulation detection circuit 100 may further include an insulation capacitance Yp between the positive terminal and the ground terminal GND, and an insulation capacitance Yn between the negative terminal and the ground terminal GND. The insulation capacitance Yp between the positive terminal and the ground terminal GND may be 1 uF (microfarad), and the insulation capacitance Yn between the negative terminal and the ground terminal GND may be 1 uF (microfarad).

As an example, referring to FIG. 2, the insulation detection circuit 100 may further include a first resistor RF1 and a second resistor RF2. One end of the first resistor RF1 is connected to the positive terminal. One end of the second resistor RF2 is separately connected to the other end of the first resistor RF1 and the voltage detection unit 30 and has a first node N. The other end of the second resistor RF2 is separately connected to the ground terminal GND and the voltage detection unit 30. The voltage detection unit 30 is further configured to:

when the power supply unit 10 is connected to the positive terminal and the power supply unit 10 provides the first power supply, detect a voltage at the first node N to obtain a fifth detection voltage (U1); and
when the power supply unit 10 is connected to the positive terminal and the power supply unit 10 provides the second power supply, detect the voltage at the first node N to obtain a sixth detection voltage (U3).

The fifth detection voltage (U1) and the first detection voltage (U2) are used to determine an actual voltage (V1) of the first power supply. The sixth detection voltage (U3) and the second detection voltage (U4) are used to determine an actual voltage (V2) of the second power supply. The actual voltage of the first power supply, the actual voltage of the second power supply, the first detection voltage (U2), and the second detection voltage (U4) are used to determine the insulation resistance between the positive terminal and the ground terminal GND. The actual voltage of the first power supply, the actual voltage of the second power supply, the third detection voltage (U2'), and the fourth detection voltage (U4') are used to determine the insulation resistance between the negative terminal and the ground terminal GND.

Specifically, in an actual and real circuit, an injection voltage may vary in real time due to factors such as temperature, noise, and radiation. A function of a bridged parallel configuration of the first resistor RF1 and the second resistor RF2 is to monitor the injection voltage in real time, thereby ensuring accurate measurement of an actual voltage at an exact moment of injection. In this way, a value substituted into the formula better approximates an actual value, resulting in a more accurate result.

The actual voltage V1 of the first power supply satisfies: $V1 = \dfrac{|U1 - U2|}{R5} \times (R4 + R5)$. The actual voltage V2 of the second power supply satisfies: $V2 = \dfrac{|U3 - U4|}{R5} \times (R4 + R5)$. U1 is the fifth detection voltage, U2 is the first detection voltage, U3 is the sixth detection voltage, U4 is the second detection voltage, R4 is a resistance value of the first resistor RF1, and R5 is a resistance value of the second resistor RF2.

It will be noted that a differential operation is performed between the voltage at the first node N (that is, the fifth detection voltage U1) and the voltage between the first power supply and the ground terminal GND (that is, the first detection voltage U2) when the power supply unit 10 is connected to the positive terminal and provides the first power supply, and the differential operation is performed between the voltage at the first node N (that is, the sixth detection voltage U3) and the voltage between the second power supply and the ground terminal GND (that is, the second detection voltage U4) when the power supply unit 10 is connected to the positive terminal and provides the second power supply. In this way, errors caused by external interference can be effectively reduced, robustness of a system can be improved, and an anti-interference capability can be enhanced.

As a first example, the voltage detection unit 30 is further configured to:

if the power supply unit 10 is connected to the positive terminal and the power supply unit 10 provides the first power supply, detect a voltage between the positive terminal and the negative terminal to obtain a seventh detection

4

voltage(V3); or

if the power supply unit 10 is connected to the negative terminal and the power supply unit 10 provides the first power supply, detect a voltage between the positive terminal and the negative terminal to obtain an eighth detection voltage (V5).

The first detection voltage (U2), the third detection voltage (U2'), the actual voltage (V1) of the first power supply, the seventh detection voltage (V3), and the eighth detection voltage (V5) are used to determine the insulation resistance between the positive terminal and the ground terminal GND and the insulation resistance between the negative terminal and the ground terminal GND when the load L connected between the positive terminal and the negative terminal is in a power generation mode.

As a second example, the voltage detection unit 30 is further configured to:

if the power supply unit 10 is connected to the positive terminal and the power supply unit 10 provides the second power supply, detect the voltage between the positive terminal and the negative terminal to obtain a ninth detection voltage(V4); or

if the power supply unit 10 is connected to the negative terminal and the power supply unit 10 provides the second power supply, detect the voltage between the positive terminal and the negative terminal to obtain a tenth detection voltage (V6).

The second detection voltage (U4), the fourth detection voltage (U4'), the actual voltage (V2) of the second power supply, the ninth detection voltage (V4), and the tenth detection voltage (V6) are used to determine the insulation resistance between the positive terminal and the ground terminal GND and the insulation resistance between the negative terminal and the ground terminal GND when the load L is in the power generation mode.

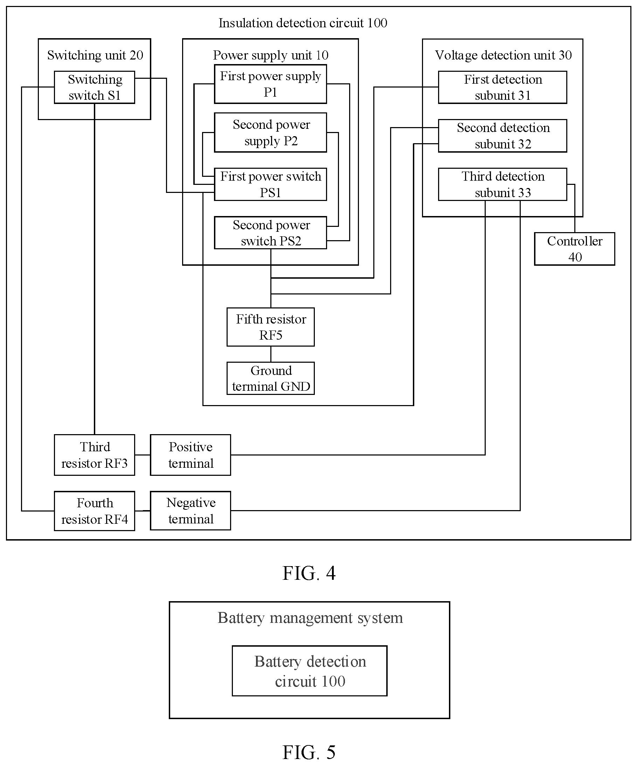

Referring to FIG. 4, the insulation detection circuit 100 may further include a controller 40, configured to determine that the load L connected between the positive terminal and the negative terminal is in the power generation mode when the seventh detection voltage (V3) and the ninth detection voltage (V4) each are greater than a first preset voltage (for example, 50 V), or when the eighth detection voltage (V5) and the tenth detection voltage (V6) each are greater than a second preset voltage (for example, 50 V). In this way, it is determined, based on the seventh detection voltage (V3) and the ninth detection voltage (V4), or the eighth detection voltage (V5) and the tenth detection voltage (V6), whether the load L connected between the positive terminal and the negative terminal is in the power generation mode.

It should be noted that, first, if the seventh detection voltage (V3) and the ninth detection voltage (V4) each are 0 V, and the eighth detection voltage (V5) and the tenth detection voltage (V6) each are 0 V, it may be confirmed that the load L is not in the power generation mode. Values of Rp and Rn (for example, an insulation resistance Rp3 between the positive terminal and the ground terminal GND and an insulation resistance Rn3 between the negative terminal and the ground terminal GND) can be calculated by using the following formula.

Second, it may further be determined, by using the load L, that the load L is in the power generation mode. In addition, whether the load L is in the power generation mode is determined based on a working condition of the load L. A hybrid mode may have a power generation mode or may not generate power, which is uncertain.

Third, when the seventh detection voltage (V3) does not exist, a mathematical model is established by mainly using the Kirchhoff's Current Law to solve an equation. When V3 exists, a mathematical model is established by mainly using the Superposition Theorem to solve an equation.

As an example, the controller 40 is further configured to:

if a first voltage change rate determined based on the seventh detection voltage (V3) and the ninth detection voltage (V4) is less than a first preset change rate (for example, 0.5 V/s), determine, based on the first detection voltage (U2), the third detection voltage (U2'), the actual voltage (V1) of the first power supply, the seventh detection voltage (V3), and the eighth detection voltage (V5), the insulation resistance between the positive terminal and the ground terminal GND and the insulation resistance between the negative terminal and the ground terminal GND; or

if a second voltage change rate (for example, 0.5 V/s) determined based on the eighth detection voltage (V5) and the tenth detection voltage (V6) is less than a second preset change rate, determine, based on the second detection voltage (U4), the fourth detection voltage (U4'), the actual voltage (V2) of the second power supply, the ninth detection voltage (V4), and the tenth detection voltage (V6), the insulation resistance between the positive terminal and the ground terminal GND and the insulation resistance between the negative terminal and the ground terminal GND.

Specifically, the first voltage change rate $ROC1 = \dfrac{|V4 - V3|}{|T1 - T2|}$ , and the second voltage change rate

$$ROC1 = \frac{|V6 - V5|}{|T1 - T2|}$$ . V3 is the seventh detection voltage (V3), V4 is the ninth detection voltage (V4), V5 is the eighth detection voltage (V5), V6 is the tenth detection voltage (V6), T1 is a moment at which the power supply unit 10 is connected to the negative terminal, and T2 is a moment at which the power supply unit 10 is connected to the positive terminal. In this way, it may be determined, based on the seventh detection voltage (V3) and the ninth detection voltage (V4), or the eighth detection voltage (V5) and the tenth detection voltage (V6), a voltage change rate of the voltage at the load terminal connected between the positive terminal and the negative terminal.

It should be noted that if the first voltage change rate determined based on the seventh detection voltage (V3) and the ninth detection voltage (V4) is greater than or equal to the first preset change rate, the seventh detection voltage (V3) and the ninth detection voltage (V4) need to be collected again. If the second voltage change rate determined based on the eighth detection voltage (V5) and the tenth detection voltage (V6) is greater than or equal to the second preset change rate, the eighth detection voltage (V5) and the tenth detection voltage (V6) need to be collected again.

In this way, a working mode of the load is identified by using the voltage (that is, the voltage at the load terminal) between the positive terminal and the negative terminal and the voltage change rate, so that circuit topologies of different working modes are switched flexibly. The voltage at the load terminal and the voltage change rate are substituted into different sets of equations for solving, so as to better calculate the insulation resistance.

Referring to FIG. 3 and FIG. 4, the switching unit 20 may include a switching switch S1. A first terminal of the switching switch S1 is connected to a first terminal of the power supply unit 10, a second terminal of the switching switch S1 is connected to the positive terminal by using a third resistor RF3, and a third terminal of the switching switch S1 is connected to the negative terminal by using a fourth resistor RF4.

Specifically, when the first terminal of the switching switch S1 is connected to the second terminal, the power supply unit 10 is connected to the positive terminal. When the first terminal of the switching switch S1 is connected to the third terminal, the power supply unit 10 is connected to the negative terminal.

Referring to FIG. 2 and FIG. 3, the power supply unit 10 may include a first power supply P1, a second power supply P2, a first power switch PS1, and a second power switch PS2.

A first terminal of the first power switch PS1 is connected to the first terminal of the switching switch S1, a second terminal of the first power switch PS1 is connected to a negative electrode of the first power supply P1, and a third terminal of the first power switch PS1 is connected to a negative electrode of the second power supply P2.

A first terminal of the second power switch PS2 is connected to the ground terminal GND by using a fifth resistor RF5, a second terminal of the second power switch PS2 is connected to a positive electrode of the first power supply P1, and a third terminal of the second power switch PS2 is connected to a positive electrode of the second power supply P2. It should be noted that configuring the first power supply P1 and the second power supply P2 with opposite polarities is theoretically feasible, but the resulting error is relatively large. In the present disclosure, by configuring the first power supply P1 and the second power supply P2 with a same polarity, a voltage difference is used to eliminate (reduce) an error value.

Specifically, when the first terminal of the first power switch PS1 is connected to the second terminal, and the first terminal of the second power switch PS2 is connected to the second terminal, the power supply unit 10 provides the first power supply P1. When the first terminal of the first power switch PS1 is connected to the third terminal, and the first terminal of the second power switch PS2 is connected to the third terminal, the power supply unit 10 provides the second power supply P2.

Specifically, when the load L connected between the positive terminal and the negative terminal is in the power generation mode, and the power supply unit 10 provides the first power supply P1, a first insulation resistance may include an insulation resistance Rp1 between the positive terminal and the ground terminal GND and an insulation resistance Rn1 between the negative terminal and the ground terminal GND.

$$Rp1 = -\frac{U2'R3V3 - R3U2V5 - R5U2V5 - R5U2V3 - R5V1V3 + R5V1V5 + R5V3V5}{V1U2' - U2V1 + V3U2'};$$

$$Rn1 = \frac{U2'R3V3 - R3U2V5 + R5U2V5 + U2'R5V3 - R3V1V3 + R5V1V5 + R5V3V5}{U2'V1 - U2V1 + U2V5};$$

wherein U2 is the first detection voltage, U2' is the third detection voltage, R3 is a resistance value of the third resistor RF3, R5 is a resistance value of the fifth resistor RF5, V3 is the seventh detection voltage, V5 is the eighth detection voltage, and V1 is the actual voltage of the first power supply P1.

When the load L is in the power generation mode, and the power supply unit 10 provides the second power supply P2, a second insulation resistance may include an insulation resistance Rp2 between the positive terminal and the ground terminal GND and an insulation resistance Rn2 between the negative terminal and the ground terminal GND.

$$Rp2 = -\frac{R5^2 U'4 V4 - R5^2 U4 V6 + R5^2 V2 V4 + R5^2 V2 V6 + R5^2 V4 V6 - R3R5U4V6 + R5R4U4'V4}{U4'R4^2U4 - R3U4U4' - R5U4V2 + R5U4'V2 + R5U4'V4};$$

$$Rn2 = \frac{R5^2 U'4 V4 - R5^2 U4 V6 - R5^2 V2 V4 + R5^2 V2 V6 + R5^2 V4 V6 - R3R5U4V6 + R5R4U4'V4}{R4U4U4' - R3U4U4' + R5U4V2 + R5U4V6 + R5U4'V2}$$

;

wherein U4 is the second detection voltage, U4' is the fourth detection voltage, R3 is a resistance value of the third resistor RF3, R4 is a resistance value of the fourth resistor RF4, R5 is a resistance value of the fifth resistor RF5, V4 is the ninth detection voltage, V6 is the tenth detection voltage, and V2 is the actual voltage of the second power supply P2.

When the load L is not in the power generation mode, the insulation resistance includes the insulation resistance Rp3 between the positive terminal and the ground terminal GND and the insulation resistance Rn3 between the negative terminal and the ground terminal GND.

$$Rp3 = \frac{R5(V1 - V2)}{|U2 - U4|} - R3 - R5 \; ; \; Rn3 = \frac{R5(V1 - V2)}{|U2' - U4'|} - R4 - R5 \; ;$$

wherein V1 is the actual voltage of the first power supply P1, V2 is the actual voltage of the second power supply P2, U2 is the first detection voltage, U2' is the third detection voltage, U4 is the second detection voltage, U4' is the fourth detection voltage, R3 is the resistance value of the third resistor RF3, R4 is the resistance value of the fourth resistor RF4, and R5 is the resistance value of the fifth resistor RF5.

In this way, when the insulation resistance at the load terminal is calculated, there is no need to concern an impact of a working mode, a state, and the like of the load, thereby reducing misjudgments and improving accuracy of an insulation system.

Referring to FIG. 4, the voltage detection unit 30 may include a first detection subunit 31, a second detection subunit 32, and a third detection subunit 33.

The first detection subunit 31 is connected to the first terminal of the second power switch PS2, and is configured to detect the voltage between the first power supply P1 or the second power supply P2 and the ground terminal GND.

The second detection subunit 32 is separately connected to the first terminal of the first power switch PS1 and the first terminal of the second power switch PS2, and is configured to detect the voltage at the first node N.

The third detection subunit 33 is separately connected to the positive terminal and the negative terminal, and is configured to detect the voltage between the positive terminal and the negative terminal.

Referring to FIG. 3, the first detection subunit 31 may include:

a first amplifier A1, wherein a first input terminal of the first amplifier A1 is connected to the first terminal of the second power switch PS2, and a second input terminal of the first amplifier A1 is connected to an output terminal of the first amplifier A1; and
a second amplifier A2, wherein a first input terminal of the second amplifier A2 is connected to the output terminal of the first amplifier A1, a second input terminal of the second amplifier A2 is connected to a first reference voltage supply terminal, and an output terminal of the second amplifier A2 serves as an output terminal of the first detection subunit 31.

It should be noted that the first amplifier A1 functions as a voltage follower, but an input voltage for the voltage follower needs to meet a range of -5V to 5V. In other words, the first reference voltage supply terminal needs to meet the range of -5V to 5V. The second amplifier A2 functions as a subtractor, and is responsible for further subtracting and amplifying a pre-stage voltage.

Referring to FIG. 3, the second detection subunit 32 may include a third amplifier A3 and a fourth amplifier A4.

In this example, for the third amplifier A3, a first input terminal of the third amplifier A3 is connected to the first node N, and a second input terminal of the third amplifier A3 is connected to an output terminal of the third amplifier A3.

For the fourth amplifier A4, a first input terminal of the fourth amplifier A4 is connected to the output terminal of the third amplifier A3, a second input terminal of the fourth amplifier A4 is connected to a second reference voltage supply terminal, and an output terminal of the fourth amplifier A4 serves as an output terminal of the second detection subunit 32.

Specifically, positive power supply terminals of the first amplifier A1, the second amplifier A2, the third amplifier A3, and the fourth amplifier A4 may be connected to a voltage of 5 V. The third amplifier A3 functions as a voltage follower, but an input voltage for the voltage follower needs to meet the range of -5V to 5V. In other words, the second reference voltage supply terminal needs to meet the range of -5V to 5V. The fourth amplifier A4 functions as a subtractor, and is responsible for further subtracting and amplifying a pre-stage voltage. Third, the positive power supply terminals of the first amplifier A1, the second amplifier A2, the third amplifier A3, and the fourth amplifier A4 may be connected to the voltage of 5 V.

The third detection subunit 33 uses a structure of the first detection subunit 31 or a structure of the second detection subunit 32. For example, the third detection subunit 33 includes the first amplifier A1, where the first input terminal of the first amplifier A1 is connected to the positive terminal, and the second input terminal of the first amplifier A1 is connected to the output terminal of the first amplifier A1; and the second amplifier A2, where the first input terminal of the second amplifier A2 is connected to the output terminal of the first amplifier A1, the second input terminal of the second amplifier A2 is connected to the first reference voltage supply terminal, and the output terminal of the second amplifier A2 serves as an output terminal of the third detection subunit 33.

It will be noted that the first amplifier A1 functions as a voltage follower, but an input voltage for the voltage follower needs to meet the range of -5V to 5V. In other words, the first reference voltage supply terminal needs to meet the range of -5V to 5V. The second amplifier A2 functions as a subtractor, and is responsible for further subtracting and amplifying a pre-stage voltage.

Referring to FIG. 3, the voltage detection unit 30 may further include:

an AD (Analogue to Digital conversion) conversion module 34. A first AD sampling terminal AINP_A of the AD conversion module 34 is connected to the output terminal of the first detection subunit 31, to perform AD sampling on a detection voltage output from the first detection subunit 31. A second AD sampling terminal AINP_B of the AD conversion module 34 is connected to the output terminal of the second detection subunit 32, to perform AD sampling on a detection voltage output from the second detection subunit 32.

Specifically, the first AD sampling terminal AINP_A of the AD conversion module 34 is connected to the output terminal of the second amplifier A2 to perform AD sampling on the detection voltage output from the first detection subunit 31, and the second AD sampling terminal AINP_B of the AD conversion module 34 is connected to the output terminal of the fourth amplifier A4 to perform AD sampling on the detection voltage output from the second detection subunit 32. It should be noted that the AD conversion module 34 plays a role in converting an analog signal to a digital signal, and may be an AD port of an MCU (Motor Control Unit) or may be a dedicated AD conversion chip.

Referring to FIG. 3, the insulation detection circuit 100 may further include a main positive switch K1 and a main negative switch K2.

One end of the main positive switch K1 is connected to a positive electrode of a battery B, and the other end of the main positive switch K1 is connected to a positive electrode of the load L. One end of the main negative switch K2 is connected to a negative electrode of the load L, and the other end of the main negative switch K2 is connected to a negative electrode of the battery B.

When a to-be-tested object is the battery B, both the main positive switch K1 and the main negative switch K2 are closed, and when the to-be-tested object is the load L, both the main positive switch K1 and the main negative switch K2 are open.

In conclusion, the insulation detection circuit 100 can predict a condition of the insulation resistance at the load terminal in advance when both the main positive switch and the main negative switch are open. In this way, a vehicle with poor insulation can be identified at an entire vehicle end in advance, thereby achieving a pre-warning effect and enhancing safety and reliability of the vehicle. In addition, when the insulation resistance at the load terminal is calculated, there is no need to concern the impact of the working mode, the state, and the like of the load, thereby reducing misjudgments and improving the accuracy of the insulation system. The differential operation is performed between the supply voltage of the first power supply and the supply voltage of the second power supply, so that errors caused by external interference can be effectively reduced, the robustness of the system can be improved, and the anti-interference capability can be enhanced.

The present disclosure further provides a battery management system.

FIG. 5 is a schematic diagram of a battery management system according to an embodiment of the present disclosure. As shown in FIG. 5, the battery management system includes the foregoing insulation detection circuit 100.

According to the battery management system in this embodiment of the present disclosure, regardless of whether a power supply unit is connected to a positive terminal or a negative terminal of a load, detection of insulation resistance at a ground terminal can be implemented by using the insulation detection circuit.

The present disclosure further provides a vehicle.

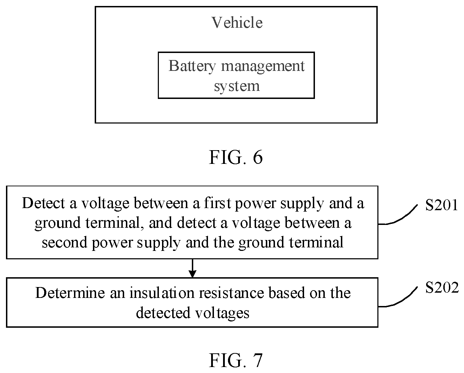

FIG. 6 is a schematic diagram of a vehicle according to an embodiment of the present disclosure. As shown in FIG. 6, the vehicle includes the foregoing battery management system.

According to the vehicle in the embodiments of the present disclosure, regardless of whether a power supply unit is connected to a positive terminal or a negative terminal of a load, detection of an insulation resistance at a ground terminal can be implemented by using the battery management system.

FIG. 7 is a schematic flowchart of an insulation detection method according to an embodiment of the present disclosure. The insulation detection method is applied to a battery management system. The battery management system includes a power supply unit 10 and a switching unit 20. The power supply unit 10 is suitable for providing a first power supply P1 and a second power supply P2. A supply voltage of the first power supply P1 is different from a supply voltage of the second power supply P2. The switching unit 20 is suitable for switching the power supply unit 10 to be connected to a positive terminal of a load L or a negative terminal of the load L. As shown in FIG. 4, the insulation detection method includes the following steps:

S201: detect a voltage between the first power supply P1 and a ground terminal GND, and detect a voltage between the second power supply P2 and the ground terminal GND.

S202: determine an insulation resistance based on the detected voltages.

It will be noted that for another specific implementation of the insulation detection method in this embodiment of the present disclosure, refer to a specific implementation of the insulation detection circuit 100 in the foregoing embodiments of the present disclosure.

In conclusion, in the insulation detection method, the condition of the insulation resistance at the load terminal can be predicted in advance when both the main positive switch and the main negative switch are open. In this way, a vehicle with poor insulation can be identified at the entire vehicle end in advance, thereby achieving the pre-warning effect and enhancing safety and reliability of the vehicle. In addition, when the insulation resistance at the load terminal is calculated, there is no need to concern the impact of the working mode, the state, and the like of the load, thereby reducing misjudgments and improving accuracy of the insulation system. The differential operation is performed between the supply voltage of the first power supply and the supply voltage of the second power supply, so that the errors caused by external interference can be effectively reduced, the robustness of the system can be improved, and the anti-interference capability can be enhanced.

It will be noted that the logic and/or steps represented in the flowchart or described herein in another manner, for example, may be considered as an ordered list of executable instructions for implementing logical functions, and may be specifically implemented in any computer-readable medium, for use by an instruction execution system, apparatus, or device (for example, a computer-based system, a system including a processor, or another system that can fetch instructions from an instruction execution system, apparatus, or device and execute the instructions), or use in combination with the instruction execution system, apparatus, or device. In terms of this specification, the "computer-readable medium" may be any apparatus that may include, store, communicate, propagate, or transmit a program for use by or in combination with an instruction execution system, apparatus, or device. More specific examples (a non-exhaustive list) of the computer-readable medium include the following: an electrical connection part (electronic apparatus) having one or more cables, a portable computer disc box (magnetic apparatus), a random access memory (RAM), a read-only memory (ROM), an erasable programmable read-only memory (EPROM or a flash memory), an optical fiber apparatus, and a compact disc read-only memory (CDROM). In addition, the computer-readable medium may even be a paper or another suitable medium on which the program can be printed, since the program may be electronically obtained, for example, by optically scanning the paper or another medium and then performing editing, interpreting, or processing in another proper manner if necessary, and then the program is stored in a computer memory.

It will be understood that the parts of the present disclosure may be implemented by hardware, software, firmware, or a combination thereof. In the foregoing implementations, the plurality of steps or methods may be implemented by software or firmware stored in a memory and executed by a proper instruction execution system. For example, if the plurality of steps or methods are implemented by hardware, as in another implementation, the plurality of steps or methods may be implemented by using any one or a combination of the following technologies known in the art: a discrete logic circuit having a logic gate circuit for implementing a logical function for a data signal, an application-specific integrated circuit having a proper combined logic gate circuit, a programmable gate array (PGA), a field programmable gate array (FPGA), and the like.

In the description of this specification, description of reference terms such as "an embodiment", "some embodiments", "an example", "a specific example", or "some examples" mean that specific features, structures, materials, or characteristics described with reference to this embodiment or example are included in at least one embodiment or example of the present disclosure. In this specification, illustrative expressions of the foregoing terms do not necessarily refer to a same embodiment or example. Furthermore, the described specific features, structures, materials, or characteristics may be combined in any one or more embodiments or examples in a suitable manner.

In the description of the present disclosure, it will be understood that the orientations or positional relationships indicated by the terms "center", "longitudinal", "transversal", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like are based on the orientation or positional relationship shown in the accompanying drawings, and are only for ease of describing the present disclosure and simplifying the description, rather than indicating or implying that an indicated apparatus or element must have a specific orientation or must be constructed and operated in a specific orientation. Therefore, this cannot be understood as a limitation on the present disclosure.

In addition, the terms such as "first" and "second" used in the embodiments of the present disclosure are used for a descriptive purpose only and shall not be construed as indicating or implying relative importance or implicitly indicating the quantity of the technical features indicated in the embodiments. Therefore, features defined with terms such as "first" and "second" in the embodiments of the present disclosure may explicitly or implicitly indicate that the embodiments include at least one feature. In the description of the present disclosure, the expression "a plurality of' means at least two or two or more, for example, two, three, four, etc., unless otherwise clearly and specifically limited in the embodiments.

In the present disclosure, unless otherwise clearly specified or limited in the embodiments, terms such as "installed", "connected", "connection", and "fixed" that appear in the embodiments will be understood in a broad sense. For example, the connection may be a fixed connection, may be a detachable connection, or may be an integrated connection; it can be understood that the connection may be a mechanical connection, an electrical connection, or the like; and certainly, the connection may be a direct connection, or an indirect connection through an intermediate medium, or may be an internal communication of two elements, or an interaction relationship between two elements. For a person of ordinary skill in the art, a specific meaning of the foregoing terms in the present disclosure can be understood based on a specific implementation situation.

In the present disclosure, unless otherwise explicitly specified and defined, that the first feature is "above" or "below" the second feature may be that the first feature and the second feature are in direct contact, or the first feature and the second feature are in indirect contact through an intermediate medium. In addition, that the first feature is "on", "above", and "over" the second feature may be that the first feature is directly above or obliquely above the second feature, or merely indicates that a horizontal height of the first feature is higher than that of the second feature. That the first feature is "under", "below", or "beneath" the second feature may be that the first feature is directly below or obliquely below the second feature, or merely indicates that a horizontal height of the first feature is less than that of the second feature.

Although the embodiments of the present disclosure have been shown and described above, it can be understood that the foregoing embodiments are examples and cannot be construed as limitations on the present disclosure, and a person of ordinary skill in the art can make changes, modifications, substitutions, or variations on the foregoing embodiments within the scope of the present disclosure.

## Claims

1. An insulation detection circuit, wherein the insulation detection circuit (100) comprises:

   a power supply unit (10), suitable for providing a first power supply and a second power supply, a supply voltage of the first power supply being different from a supply voltage of the second power supply;
   a switching unit (20), suitable for switching the power supply unit (10) to be connected to a positive terminal of a load or a negative terminal of the load; and
   a voltage detection unit (30), configured to detect a voltage between the first power supply and a ground terminal, and detect a voltage between the second power supply and the ground terminal;
   the voltages detected by the voltage detection unit (30) being used to determine an insulation resistance.

2. The insulation detection circuit according to claim 1, wherein the voltage detection unit (30) is configured to: when the power supply unit (10) is connected to the positive terminal,

   if the power supply unit (10) provides the first power supply, detect the voltage between the first power supply and the ground terminal to obtain a first detection voltage; or
   if the power supply unit (10) provides the second power supply, detect the voltage between the second power supply and the ground terminal to obtain a second detection voltage; and
   the voltage detection unit (30) is further configured to: when the power supply unit (10) is connected to the negative terminal,
   if the power supply unit (10) provides the first power supply, detect the voltage between the first power supply and the ground terminal to obtain a third detection voltage; or
   if the power supply unit (10) provides the second power supply, detect the voltage between the second power supply and the ground terminal to obtain a fourth detection voltage;
   the first detection voltage to the fourth detection voltage being used to determine an insulation resistance between the positive terminal and the ground terminal and an insulation resistance between the negative terminal and the ground terminal.

3. The insulation detection circuit according to claim 2, wherein the insulation detection circuit (100) further comprises a first resistor and a second resistor, one end of the first resistor being connected to the positive terminal, one end of the second resistor being separately connected to the other end of the first resistor and the voltage detection unit (30) and having a first node, and the other end of the second resistor being separately connected to the ground terminal and the voltage detection unit (30); and the voltage detection unit (30) is further configured to:

when the power supply unit (10) is connected to the positive terminal and the power supply unit (10) provides the first power supply, detect a voltage at the first node to obtain a fifth detection voltage; and
when the power supply unit (10) is connected to the positive terminal and the power supply unit (10) provides the second power supply, detect the voltage at the first node to obtain a sixth detection voltage;
the fifth detection voltage and the first detection voltage being used to determine an actual voltage of the first power supply, the sixth detection voltage and the second detection voltage being used to determine an actual voltage of the second power supply, the actual voltage of the first power supply, the actual voltage of the second power supply, the first detection voltage, and the second detection voltage being used to determine the insulation resistance between the positive terminal and the ground terminal, and the actual voltage of the first power supply, the actual voltage of the second power supply, the third detection voltage, and the fourth detection voltage being used to determine the insulation resistance between the negative terminal and the ground terminal.

4. The insulation detection circuit according to claim 3, wherein the voltage detection unit (30) is further configured to:

if the power supply unit (10) is connected to the positive terminal and the power supply unit (10) provides the first power supply, detect a voltage between the positive terminal and the negative terminal to obtain a seventh detection voltage; or
if the power supply unit (10) is connected to the negative terminal and the power supply unit (10) provides the first power supply, detect a voltage between the positive terminal and the negative terminal to obtain an eighth detection voltage;
the first detection voltage, the third detection voltage, the actual voltage of the first power supply, the seventh detection voltage, and the eighth detection voltage being used to determine the insulation resistance between the positive terminal and the ground terminal and the insulation resistance between the negative terminal and the ground terminal when the load connected between the positive terminal and the negative terminal is in a power generation mode.

5. The insulation detection circuit according to claim 4, wherein the voltage detection unit (30) is further configured to:

if the power supply unit (10) is connected to the positive terminal and the power supply unit (10) provides the second power supply, detect the voltage between the positive terminal and the negative terminal to obtain a ninth detection voltage; or
if the power supply unit (10) is connected to the negative terminal and the power supply unit (10) provides the second power supply, detect the voltage between the positive terminal and the negative terminal to obtain a tenth detection voltage;
the second detection voltage, the fourth detection voltage, the actual voltage of the second power supply, the ninth detection voltage, and the tenth detection voltage being used to determine the insulation resistance between the positive terminal and the ground terminal and the insulation resistance between the negative terminal and the ground terminal when the load is in the power generation mode.

6. The insulation detection circuit according to any one of claims 3-5, wherein the switching unit (20) comprises a switching switch, a first terminal of the switching switch being connected to a first terminal of the power supply unit (10), a second terminal of the switching switch being connected to the positive terminal by using a third resistor, and a third terminal of the switching switch being connected to the negative terminal by using a fourth resistor.

7. The insulation detection circuit according to claim 6, wherein the power supply unit (10) comprises the first power supply, the second power supply, a first power switch, and a second power switch;

a first terminal of the first power switch being connected to the first terminal of the switching switch, a second terminal of the first power switch being connected to a negative electrode of the first power supply, and a third terminal of the first power switch being connected to a negative electrode of the second power supply; and
a first terminal of the second power switch being connected to the ground terminal by using a fifth resistor, a second terminal of the second power switch being connected to a positive electrode of the first power supply, and a third terminal of the second power switch being connected to a positive electrode of the second power supply.

8. The insulation detection circuit according to claim 7, wherein the voltage detection unit (30) comprises a first detection subunit (31), a second detection subunit (32), and a third detection subunit (33);

the first detection subunit (31) being connected to the first terminal of the second power switch, and being configured to detect the voltage between the first power supply or the second power supply and the ground terminal;

the second detection subunit (32) being separately connected to the first terminal of the first power switch and the first terminal of the second power switch, and being configured to detect the voltage at the first node; and

the third detection subunit (33) being separately connected to the positive terminal and the negative terminal, and being configured to detect the voltage between the positive terminal and the negative terminal.

9. The insulation detection circuit according to claim 8, wherein the first detection subunit (31) comprises:

a first amplifier, a first input terminal of the first amplifier being connected to the first terminal of the second power switch, and a second input terminal of the first amplifier being connected to an output terminal of the first amplifier; and

a second amplifier, a first input terminal of the second amplifier being connected to the output terminal of the first amplifier, a second input terminal of the second amplifier being connected to a first reference voltage supply terminal, and an output terminal of the second amplifier serving as an output terminal of the first detection subunit (31).

10. The insulation detection circuit according to claim 8 or 9, wherein the second detection subunit (32) comprises:

a third amplifier, a first input terminal of the third amplifier being connected to the first node, and a second input terminal of the third amplifier being connected to an output terminal of the third amplifier; and

a fourth amplifier, a first input terminal of the fourth amplifier being connected to the output terminal of the third amplifier, a second input terminal of the fourth amplifier being connected to a second reference voltage supply terminal, and an output terminal of the fourth amplifier serving as an output terminal of the second detection subunit (32).

11. The insulation detection circuit according to claim 8, 9, or 10, wherein the voltage detection unit (30) further comprises: an AD conversion module, a first AD sampling terminal of the AD conversion module being connected to the output terminal of the first detection subunit (31), to perform AD sampling on a detection voltage output from the first detection subunit (31); and a second AD sampling terminal of the AD conversion module being connected to the output terminal of the second detection subunit (32), to perform AD sampling on a detection voltage output from the second detection subunit (32).

12. The insulation detection circuit according to claim 5, wherein the insulation detection circuit (100) further comprises: a controller (40), configured to determine that the load connected between the positive terminal and the negative terminal is in the power generation mode when the seventh detection voltage and the ninth detection voltage each are greater than a first preset voltage, or when the eighth detection voltage and the tenth detection voltage each are greater than a second preset voltage.

13. The insulation detection circuit according to claim 12, wherein the controller (40) is further configured to:

if a first voltage change rate determined based on the seventh detection voltage and the ninth detection voltage is less than a first preset change rate, determine the insulation resistance between the positive terminal and the ground terminal and the insulation resistance between the negative terminal and the ground terminal based on the first detection voltage, the third detection voltage, the actual voltage of the first power supply, the seventh detection voltage, and the eighth detection voltage; or

if a second voltage change rate determined based on the eighth detection voltage and the tenth detection voltage is less than a second preset change rate, determine the insulation resistance between the positive terminal and the ground terminal and the insulation resistance between the negative terminal and the ground terminal based on the second detection voltage, the fourth detection voltage, the actual voltage of the second power supply, the ninth detection voltage, and the tenth detection voltage.

14. A battery management system, comprising the insulation detection circuit (100) according to any one of claims 1 to 13.

**15.** A vehicle, wherein the vehicle comprises the battery management system according to claim 14.

**16.** An insulation detection method, applied to a battery management system, the battery management system comprising a power supply unit (10) and a switching unit (20), the power supply unit (10) being suitable for providing a first power supply and a second power supply, a supply voltage of the first power supply being different from a supply voltage of the second power supply, and the switching unit (20) being suitable for switching the power supply unit (10) to be connected to a positive terminal of a load or a negative terminal of the load; and the method comprising:

detecting a voltage between the first power supply and a ground terminal, and detecting a voltage between the second power supply and the ground terminal; and
determining an insulation resistance based on the detected voltages.

Insulation detection circuit 100

Switching unit 20 — Power supply unit 10

Voltage detection unit 30

Load L — Ground terminal GND

FIG. 1

Insulation detection circuit 100

Switching unit 20 — Power supply unit 10 — Voltage detection unit 30

First resistor RF1 — Positive terminal of a load L

N

Second resistor RF2 — Ground terminal GND

FIG. 2

FIG. 3

FIG. 4

FIG. 5

Vehicle

Battery management
system

FIG. 6

Detect a voltage between a first power supply and a
ground terminal, and detect a voltage between a
second power supply and the ground terminal

S201

Determine an insulation resistance based on the
detected voltages

S202

FIG. 7

## INTERNATIONAL SEARCH REPORT

| International application No. |
| --- |
| **PCT/CN2024/100168** |

**A. CLASSIFICATION OF SUBJECT MATTER**

G01R27/02(2006.01)i; B60L3/00(2019.01)i; B60L58/10(2019.01)i

According to International Patent Classification (IPC) or to both national classification and IPC

**B. FIELDS SEARCHED**

Minimum documentation searched (classification system followed by classification symbols)

IPC:G01R,B60L

Documentation searched other than minimum documentation to the extent that such documents are included in the fields searched

Electronic data base consulted during the international search (name of data base and, where practicable, search terms used)

CNTXT, ENTXTC, CNKI, ENTXT, VEN: 绝缘, 测, 电源, 切换, 电压, 绝缘电阻, 绝缘阻值, 绝缘阻抗, 正极, 负极, 预设电压, 阈值, 变化速率, insulation, detect, measure, test, power supply, switch, voltage, insulation resistance, insulation resistor, insulation impedance, positive electrode, negative electrode, positive terminal, negative terminal, threshold, rate of change, different

**C. DOCUMENTS CONSIDERED TO BE RELEVANT**

| Category* | Citation of document, with indication, where appropriate, of the relevant passages | Relevant to claim No. |
| --- | --- | --- |
| Y | CN 105527498 A (BYD CO., LTD.) 27 April 2016 (2016-04-27) description, paragraphs 0005-0060, and figures 1-2 and 4 | 1-16 |
| Y | CN 113466737 A (BYD CO., LTD.) 01 October 2021 (2021-10-01) description, paragraphs 0005-0055, and figure 5 | 1-16 |
| Y | CN 106546801 A (BYD CO., LTD.) 29 March 2017 (2017-03-29) description, paragraphs 0007-0066, and figures 2-3 | 1-16 |
| Y | CN 106814254 A (BYD CO., LTD.) 09 June 2017 (2017-06-09) description, paragraphs 0006-0067, and figure 2 | 1-16 |
| A | CN 104101784 A (BYD CO., LTD.) 15 October 2014 (2014-10-15) entire document | 1-16 |
| A | CN 108427057 A (SHENZHEN GUOXIN-POWER TECHNOLOGY CO., LTD.) 21 August 2018 (2018-08-21) entire document | 1-16 |

☑ Further documents are listed in the continuation of Box C. ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **12 September 2024** | **22 September 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/100168**

### C. DOCUMENTS CONSIDERED TO BE RELEVANT

| Category* | Citation of document, with indication, where appropriate, of the relevant passages | Relevant to claim No. |
|---|---|---|
| A | CN 108572278 A (SHENZHEN AVADI TECHNOLOGY CO., LTD.) 25 September 2018 (2018-09-25) entire document | 1-16 |
| A | CN 109917186 A (JIANGSU MAIJI YIWEI ELECTRIC TECHNOLOGY CO., LTD.) 21 June 2019 (2019-06-21) entire document | 1-16 |
| A | CN 110927462 A (CHINA NORTH VEHICLE RESEARCH INSTITUTE) 27 March 2020 (2020-03-27) entire document | 1-16 |
| A | CN 110967606 A (CONTEMPORARY AMPEREX TECHNOLOGY CO., LTD.) 07 April 2020 (2020-04-07) entire document | 1-16 |
| A | US 2013314097 A1 (HAUSBERGER INGO et al.) 28 November 2013 (2013-11-28) entire document | 1-16 |
| A | US 2020313248 A1 (LG CHEMICAL LTD.) 01 October 2020 (2020-10-01) entire document | 1-16 |

Form PCT/ISA/210 (second sheet) (July 2022)

## INTERNATIONAL SEARCH REPORT
### Information on patent family members

International application No.

**PCT/CN2024/100168**

| Patent document cited in search report | | | Publication date (day/month/year) | Patent family member(s) | | | Publication date (day/month/year) |
|---|---|---|---|---|---|---|---|
| CN | 105527498 | A | 27 April 2016 | None | | | |
| CN | 113466737 | A | 01 October 2021 | None | | | |
| CN | 106546801 | A | 29 March 2017 | None | | | |
| CN | 106814254 | A | 09 June 2017 | None | | | |
| CN | 104101784 | A | 15 October 2014 | None | | | |
| CN | 108427057 | A | 21 August 2018 | None | | | |
| CN | 108572278 | A | 25 September 2018 | None | | | |
| CN | 109917186 | A | 21 June 2019 | None | | | |
| CN | 110927462 | A | 27 March 2020 | None | | | |
| CN | 110967606 | A | 07 April 2020 | WO | 2020147749 | A1 | 23 July 2020 |
| | | | | US | 2021231726 | A1 | 29 July 2021 |
| | | | | US | 11448683 | B2 | 20 September 2022 |
| | | | | EP | 3779486 | A1 | 17 February 2021 |
| | | | | EP | 3779486 | B1 | 10 August 2022 |
| US | 2013314097 | A1 | 28 November 2013 | EP | 2570289 | A1 | 20 March 2013 |
| | | | | EP | 2570289 | B1 | 15 August 2018 |
| | | | | US | 9244108 | B2 | 26 January 2016 |
| US | 2020313248 | A1 | 01 October 2020 | EP | 3709038 | A1 | 16 September 2020 |
| | | | | EP | 3709038 | B1 | 07 June 2023 |
| | | | | JP | 2021503596 | A | 12 February 2021 |
| | | | | JP | 6930705 | B2 | 01 September 2021 |
| | | | | WO | 2020045968 | A1 | 05 March 2020 |
| | | | | KR | 20200024000 | A | 06 March 2020 |
| | | | | KR | 102256096 | B1 | 27 May 2021 |
| | | | | US | 11581590 | B2 | 14 February 2023 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311001079